# EUROPEAN PATENT SPECIFICATION

(11) **EP 4 404 327 B1**
(45) Date of publication and mention of the grant of the patent: **01.04.2026**
(21) Application number: 22913988.6
(22) Date of filing: 30.11.2022
(51) Int. Cl.: H01M 10/44, G01R 31/396

(54) **BATTERY MANAGEMENT METHOD AND APPARATUS, AND COMPUTER-READABLE STORAGE MEDIUM**
BATTERIEVERWALTUNGSVERFAHREN UND -VORRICHTUNG SOWIE COMPUTERLESBARES SPEICHERMEDIUM
PROCÉDÉ ET APPAREIL DE GESTION DE BATTERIE ET SUPPORT D'ENREGISTREMENT LISIBLE PAR ORDINATEUR

(30) Priority: 30.12.2021 CN 202111681358
(43) Date of publication of application: 24.07.2024
(73) Proprietor: BYD Company Limited, Shenzhen, Guangdong 518118 (CN)
(72) Inventor: DENG, Linwang, Shenzhen, Guangdong 518118 (CN); LI, Xiaoqian, Shenzhen, Guangdong 518118 (CN); FENG, Tianyu, Shenzhen, Guangdong 518118 (CN); HONG, Jingjing, Shenzhen, Guangdong 518118 (CN)
(74) Representative: Dehns Germany Partnerschaft mbB
(86) International application number: PCT/CN2022/135668
(87) International publication number: WO 2023/124733

(56) References cited:
- EP-A1- 3 761 475
- CN-A- 109 428 356
- CN-A- 111 142 039
- CN-A- 113 376 525
- CN-B- 108 134 142
- KR-A- 20210 046 407
- YAZAMI R ET AL: "A kinetics study of self-discharge of spinel electrodes in Li/Li"xMn"2O"4 cells", JOURNAL OF POWER SOURCES, ELSEVIER, AMSTERDAM, NL, vol. 153, no. 2, 28 February 2006 (2006-02-28), pages 251 - 257, XP025083718, ISSN: 0378-7753, [retrieved on 20060228], DOI: 10.1016/J.JPOWSOUR.2005.10.012

## Description

### FIELD

The present invention relates to the field of battery technologies, and more specifically, to a battery management method and management apparatus, and a computer-readable storage medium.

### BACKGROUND

Power batteries are widely used in the fields of electric vehicle power sources and backup power sources. To increase energy and a voltage of the power batteries, several cells need to be connected in series to form a power battery pack for use. However, in a process of producing the cells, due to a production process, a self-discharge rate of each cell is different. The difference in the self-discharge rates leads to inconsistent states of charge of the cells, making each cell unable to be synchronously charged to an upper limit voltage or discharged to a lower limit voltage, which affects a capacity of an entire power battery pack. In view of this, self-discharge power of each cell needs to be detected to identify cells with a larger deviation of the self-discharge power.

Currently, detection of self-discharge of the cells is performed before leaving a factory. Specifically, before leaving the factory, the self-discharge rates of the cells are detected, and the cells with basically the same self-discharge rates are assembled into the power battery pack. However, with the use and aging of the power battery pack, the self-discharge rate of each cell changes. The foregoing self-discharge detection is only a test before leaving the factory, and the self-discharge of the power battery pack cannot be monitored during the use of the power battery pack.

The document EP 3 761 475 A1 discloses a battery management system (BMS) which performs a cell balancing method. The balancing involves the obtaining of the capacity of individual cells at respective high-voltage turning points of individual cell charging curves. However, the individual cell self-discharges are not contemplated by the method.

### SUMMARY

To resolve the foregoing technical problems, the present invention provides a battery management method, a battery management apparatus, a vehicle, and a computer-readable storage medium, which can calculate a target equivalent self-discharge value of a cell during the use of the cell, and can promptly identify a cell with abnormal self-discharge and manage the abnormal cell.

A first aspect of the present invention provides a battery management method. The battery management method includes: a current high-voltage inflection point power value corresponding to a high-voltage inflection point of a charging curve of each cell at a current moment is obtained; a current historical cumulative balance power value of each cell at the current moment is obtained; a current equivalent self-discharge value of the cell is obtained according to the current high-voltage inflection point power value of each cell and the current historical cumulative balance power value of the cell; an equivalent self-discharge value at a previous moment of each cell is obtained; the equivalent self-discharge value at the previous moment of the cell is subtracted from the current equivalent self-discharge value of each cell to obtain a target equivalent self-discharge value of the cell within an interval between the current moment and the previous moment; a maximum target equivalent self-discharge value and a minimum target equivalent self-discharge value among the target equivalent self-discharge values of all cells are determined; the maximum target equivalent self-discharge value is divided by the interval to obtain a maximum equivalent self-discharge rate, and the minimum target equivalent self-discharge value is divided by the interval to obtain a minimum equivalent self-discharge rate; and when it is determined that a difference between the maximum equivalent self-discharge rate and the minimum equivalent self-discharge rate is greater than a preset threshold, a target cell corresponding to the maximum target equivalent self-discharge value is managed.

In an embodiment, that the current equivalent self-discharge value of the cell is obtained according to the current high-voltage inflection point power value of each cell and the current historical cumulative balance power value of the cell includes:
the current historical cumulative balance power value of the cell is subtracted from the current high-voltage inflection point power value of each cell to obtain the current equivalent self-discharge value of the cell.

In an embodiment, that the current equivalent self-discharge value of the cell is obtained according to the current high-voltage inflection point power value of each cell and the current historical cumulative balance power value of the cell includes:
a minimum current high-voltage inflection point power value among current high-voltage inflection point power values of all cells is determined (S1031);
the minimum current high-voltage inflection point power value is subtracted from the current high-voltage inflection point power value of each cell to obtain a preprocessed current high-voltage inflection point power value of each cell (S1032);
a minimum current historical cumulative balance power value among current historical cumulative balance power values of all cells is determined (S1033);
the minimum current historical cumulative balance power value is subtracted from the current historical cumulative balance power value of each cell to obtain a preprocessed current historical cumulative balance power value of each cell (S1034); and
the preprocessed current historical cumulative balance power value of the cell is subtracted from the preprocessed current high-voltage inflection point power value of each cell to obtain the current equivalent self-discharge value of the cell (S1035).

In an embodiment, the battery management apparatus is applied to a vehicle, and that the target cell corresponding to the maximum target equivalent self-discharge value is managed includes:
information about the target cell is sent to the vehicle and/or a terminal that is communicatively connected to the vehicle.

In an embodiment, the information about the target cell includes a number, a location, the target equivalent self-discharge value, and an equivalent self-discharge rate of the target cell.

In an embodiment, the battery management apparatus further includes a plurality of reminder modules, each reminder module corresponds to a cell, and that the target cell corresponding to the maximum target equivalent self-discharge value is managed further includes:
a reminder module corresponding to the target cell is controlled to issue an early warning signal.

In an embodiment, the method further includes: the equivalent self-discharge value at the previous moment of the cell is replaced with the current equivalent self-discharge value of each cell to update a stored equivalent self-discharge value of the cell.

In an embodiment, that the equivalent self-discharge value at the previous moment of the cell is replaced with the current equivalent self-discharge value of each cell to update the stored equivalent self-discharge value of the cell includes:
a minimum current equivalent self-discharge value among current equivalent self-discharge values of all cells is determined;
the minimum current equivalent self-discharge value is subtracted from the current equivalent self-discharge value of each cell to obtain a preprocessed current equivalent self-discharge value of each cell; and
the equivalent self-discharge value at the previous moment of the cell is replaced with the preprocessed current equivalent self-discharge value of each cell to update the stored equivalent self-discharge value of the cell.

In an embodiment, the previous moment is a moment at which the vehicle leaves a factory, the equivalent self-discharge value at the previous moment of each cell is 0, the historical cumulative balance power value at the previous moment of each cell is 0, and the high-voltage inflection point power value at the previous moment of each cell is 0.

In an embodiment, when the current moment is current charging, a moment of the charging curve is obtained, and when the previous moment is previous charging, a moment of the charging curve is obtained.

In an embodiment, the cell is a power battery or an energy storage battery.

A second aspect of the present invention further provides a battery management apparatus. The battery management apparatus includes: a number of cells, an obtaining module, and a processing module. The obtaining module is configured to obtain a current high-voltage inflection point power value corresponding to a high-voltage inflection point of a charging curve of each cell at a current moment, a current historical cumulative balance power value of each cell at the current moment, and an equivalent self-discharge value at a previous moment of each cell. The processing module is configured to obtain a current equivalent self-discharge value of the cell according to the current high-voltage inflection point power value of each cell and the current historical cumulative balance power value of the cell; subtract the equivalent self-discharge value at the previous moment of the cell from the current equivalent self-discharge value of each cell to obtain a target equivalent self-discharge value of the cell within an interval between the current moment and the previous moment; determine a maximum target equivalent self-discharge value and a minimum target equivalent self-discharge value among the target equivalent self-discharge values of all cells; divide the maximum target equivalent self-discharge value by the interval to obtain a maximum equivalent self-discharge rate, and divide the minimum target equivalent self-discharge value by the interval to obtain a minimum equivalent self-discharge rate; and when it is determined that a difference between the maximum equivalent self-discharge rate and the minimum equivalent self-discharge rate is greater than a preset threshold, manage a target cell corresponding to the maximum target equivalent self-discharge value.

In an embodiment, that the current equivalent self-discharge value of the cell is obtained according to the current high-voltage inflection point power value of each cell and the current historical cumulative balance power value of the cell includes:
the current historical cumulative balance power value of the cell is subtracted from the current high-voltage inflection point power value of each cell to obtain the current equivalent self-discharge value of the cell.

In an embodiment, that the current equivalent self-discharge value of the cell is obtained according to the current high-voltage inflection point power value of each cell and the current historical cumulative balance power value of the cell includes:
a minimum current high-voltage inflection point power value among current high-voltage inflection point power values of all cells is determined;
the minimum current high-voltage inflection point power value is subtracted from the current high-voltage inflection point power value of each cell to obtain a preprocessed current high-voltage inflection point power value of each cell;
a minimum current historical cumulative balance power value among current historical cumulative balance power values of all cells is determined;
the minimum current historical cumulative balance power value is subtracted from the current historical cumulative balance power value of each cell to obtain a preprocessed current historical cumulative balance power value of each cell; and
the preprocessed current historical cumulative balance power value of the cell is subtracted from the preprocessed current high-voltage inflection point power value of each cell to obtain the current equivalent self-discharge value of the cell.

In an embodiment, the battery management apparatus is applied to a vehicle, the battery management apparatus further includes a communication module configured to communicate with the vehicle, and that the target cell corresponding to the maximum target equivalent self-discharge value is managed includes:
through the communication module, information about the target cell is sent to the vehicle and/or a terminal that is communicatively connected to the vehicle.

In an embodiment, the battery management apparatus further includes a plurality of reminder modules, each reminder module corresponds to a cell, and that the target cell corresponding to the maximum target equivalent self-discharge value is managed includes:
a reminder module corresponding to the target cell is controlled to issue an early warning signal.

In an embodiment, the battery management apparatus further includes a storage module, the storage module stores the equivalent self-discharge value of each cell, and the processing module is further configured to replace the equivalent self-discharge value at the previous moment of the cell with the current equivalent self-discharge value of each cell to update a stored self-discharge value of the cell.

In an embodiment, that the equivalent self-discharge value at the previous moment of the cell is replaced with the current equivalent self-discharge value of each cell to update the stored self-discharge value of the cell includes:
a minimum current equivalent self-discharge value among current equivalent self-discharge values of all cells is determined;
the minimum current equivalent self-discharge value is subtracted from the current equivalent self-discharge value of each cell to obtain a preprocessed current equivalent self-discharge value of each cell; and
the equivalent self-discharge value at the previous moment of the cell is replaced with the preprocessed current equivalent self-discharge value of each cell to update the stored equivalent self-discharge value of the cell.

A third aspect of the present invention further provides a vehicle. The vehicle includes the foregoing battery management apparatus.

A fourth aspect of the present invention further provides a computer-readable storage medium. The computer-readable storage medium stores a computer program, and the computer program is invoked by a processor to perform the foregoing battery management method.

The present invention provides a battery management method, a battery management apparatus, a vehicle, and a computer-readable storage medium. By obtaining the current high-voltage inflection point power value of the charging curve of each cell and the current historical cumulative balance power value, the current equivalent self-discharge value of each cell is obtained. The target equivalent self-discharge value of each cell is obtained by subtracting the equivalent self-discharge value at the previous moment from the current equivalent self-discharge value, so that self-discharge conditions of all cells are monitored during the use of the battery management apparatus. Then the maximum equivalent self-discharge rate and the minimum equivalent self-discharge rate are obtained through calculation by using the target equivalent self-discharge values of all cells, and when the difference between the maximum equivalent self-discharge rate and the minimum equivalent self-discharge rate is greater than the preset threshold, the target cell with the maximum equivalent self-discharge rate is managed, so that a user can promptly discover a cell with abnormal self-discharge to perform maintenance or replacement.

### BRIEF DESCRIPTION OF THE DRAWINGS

To describe the technical solutions in the present invention more clearly, the following briefly introduces the accompanying drawings required for describing the implementation manners. Apparently, the accompanying drawings in the following description show some implementation manners of the present invention, and a person of ordinary skill in the art may still derive other drawings from these accompanying drawings without creative efforts.
FIG. 1 is a flowchart of a battery management method according to an embodiment of the present invention.
FIG. 2 is a schematic diagram of a charging curve according to an embodiment of the present invention.
FIG. 3 is a schematic diagram of a voltage differential curve according to an embodiment of the present invention.
FIG. 4 is a sub-flowchart of step S103 in FIG. 1.
FIG. 5 is a block diagram of a structure of a battery management apparatus according to an embodiment of the present invention.
FIG. 6 is a block diagram of a structure of a vehicle according to an embodiment of the present invention.

### DETAILED DESCRIPTION

The technical solutions in embodiments of the present invention are clearly and completely described below with reference to the accompanying drawings in the embodiments of the present invention. Apparently, the described embodiments are merely some rather than all of the embodiments of the present invention. All other embodiments obtained by a person of ordinary skill in the art based on the embodiments of the present invention without creative efforts shall fall within the protection scope of the present invention.

In descriptions of the present invention, unless otherwise explicitly specified or defined, the term "connection" should be understood in a broad sense. For example, the connection may be a fixed connection, a detachable connection, or an integral connection; the connection may be a direct connection, an indirect connection through an intermediary, or internal communication between two components; the connection may be a communication connection; or the connection may be an electrical connection. A person of ordinary skill in the art may understand specific meanings of the terms in the present invention according to specific situations.

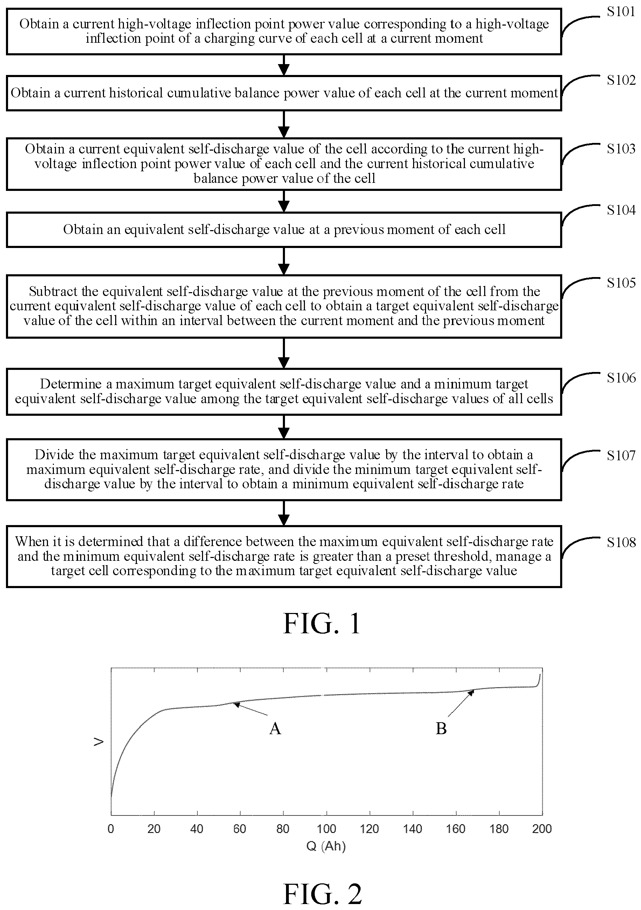

Refer to FIG. 1. FIG. 1 is a flowchart of a battery management method according to an embodiment of the present invention. The battery management method is applied to a battery management apparatus, and the battery management apparatus includes a number of cells. As shown in FIG. 1, the battery management method includes the following steps:
S101: A current high-voltage inflection point power value corresponding to a high-voltage inflection point of a charging curve of each cell at a current moment is obtained.
S102: A current historical cumulative balance power value of each cell at the current moment is obtained.
S103: According to the current high-voltage inflection point power value of each cell and the current historical cumulative balance power value of the cell, a current equivalent self-discharge value of the cell is obtained.
S104: An equivalent self-discharge value at a previous moment of each cell is obtained.
S105: The equivalent self-discharge value at the previous moment of the cell is subtracted from the current equivalent self-discharge value of each cell to obtain a target equivalent self-discharge value within an interval between the current moment and the previous moment of the cell.
S106: A maximum target equivalent self-discharge value and a minimum target equivalent self-discharge value among the target equivalent self-discharge values of all cells are determined.
S107: The maximum target equivalent self-discharge value is divided by the interval to obtain a maximum equivalent self-discharge rate, and the minimum target equivalent self-discharge value is divided by the interval to obtain a minimum equivalent self-discharge rate.
S108: When it is determined that a difference between the maximum equivalent self-discharge rate and the minimum equivalent self-discharge rate is greater than a preset threshold, a target cell corresponding to the maximum target equivalent self-discharge value is managed.

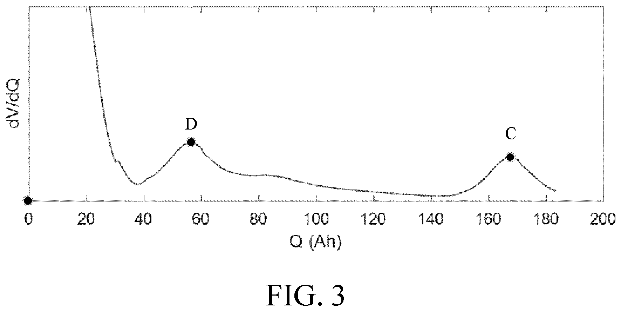

Refer to FIG. 2 and FIG. 3 together. FIG. 2 is a schematic diagram of a charging curve according to an embodiment of the present invention, and FIG. 3 is a schematic diagram of a voltage differential curve according to an embodiment of the present invention. All cells in the battery management apparatus are connected in series. When all cells are charged, a vehicle collects and records parameters of each cell in real time. The parameters include: a voltage, a current, a temperature, an SOC (state of charge), and the like. By performing data processing on the parameters, such as filtering, differentiation, integration, fitting, wavelet analysis, neural network operations, and the like, the charging curve of each cell may be obtained. As shown in FIG. 2, the charging curve is a voltage-power curve, that is, a relationship curve between a voltage and power. The voltage-power curve has three intervals at which the voltage changes relatively slowly. The interval at which the voltage changes relatively slowly is a voltage plateau region. A region in which the voltage changes relatively quickly exists between two adjacent voltage plateau regions. A point at which the voltage changes the fastest in the region in which the voltage changes relatively quickly is a voltage inflection point. The voltage-power curve has two voltage inflection points. The two voltage inflection points are a high-voltage inflection point (B in FIG. 2) and a low-voltage inflection point (A in FIG. 2). The high-voltage inflection point and the low-voltage inflection point respectively correspond to two maximum points (a maximum point C and a maximum point D) on the voltage differential curve (as shown in FIG. 3), where the high-voltage inflection point B corresponds to the maximum point C, and the low-voltage inflection point A corresponds to the maximum point D.

The current historical cumulative balance power value is a cumulative value of a balance power value obtained at the current moment and a balance power value obtained each time before the current moment.

In some embodiments, the equivalent self-discharge value at the previous moment of each cell is obtained by subtracting the historical cumulative balance power value at the previous moment of the cell from the high-voltage inflection point power value at the previous moment of each cell. The historical cumulative balance power value at the previous moment is a cumulative value of a balance power value obtained at the previous moment and a balance power value obtained each time before the previous moment.

During the use of the cell, the cell self-discharges due to current manufacturing processes. A self-discharge process of each cell is different, causing self-discharge rates of the number of cells to be inconsistent. Since the self-discharge process of the cell causes the high-voltage inflection point power value to deviate, and the self-discharge rates of the number of cells are inconsistent, the high-voltage inflection point power values of the number of cells deviate to different degrees, so that obtained high-voltage inflection point power values of all cells are different. To compensate for inconsistent remaining power of the cell due to the inconsistent self-discharge rates of the cell, the battery management apparatus may balance the number of cells. Specifically, remaining power of all cells are compared, and the cell with higher remaining power is discharged, so that the cell generates corresponding balance power. A smaller self-discharge quantity of the cell indicates more balance power generated. Therefore, the equivalent self-discharge value of the cell may be obtained through calculation by using the high-voltage inflection point power value and the historical cumulative balance power value of the cell. The equivalent self-discharge value is a relative self-discharge value. Since an absolute self-discharge value cannot be calculated, in the present invention, the equivalent self-discharge value is a relative self-discharge value of each cell.

In some embodiments, the previous moment is a moment at which the vehicle leaves a factory, the equivalent self-discharge value at the previous moment of each cell is 0, the historical cumulative balance power value at the previous moment of each cell is 0, and the high-voltage inflection point power value at the previous moment of each cell is 0.

In some embodiments, the current moment is a moment at which the charging curve is obtained during current charging, and the previous moment is a moment at which the charging curve is obtained during last charging.

In some embodiments, the interval between the current moment and the previous moment is a preset interval, that is, the current moment is a moment of the previous moment plus the preset interval. The preset interval may be set according to actual requirements, for example, may be 3 months.

A quantity of cells may be set according to actual requirements and is not limited herein.

In some embodiments, the cell may be a power battery, and the battery management apparatus may be applied to a vehicle, for example, a pure electric vehicle or a hybrid vehicle. In some other embodiments, the cell may be an energy storage battery, and the battery management apparatus may be applied to an energy storage power station, a peak regulation and frequency modulation power auxiliary service, and the like.

In step S106, when the maximum target equivalent self-discharge value and the minimum target equivalent self-discharge value among the target equivalent self-discharge values of all cells are determined, by comparing the obtained target equivalent self-discharge values of all cells, the maximum target equivalent self-discharge value and the minimum target equivalent self-discharge value are determined.

In step S108, the preset threshold may be set according to actual requirements, and is not limited herein.

Steps S106 to S108 are further described in detail below by taking a battery management apparatus including eight cells as an example.

A set of the target equivalent self-discharge values of all cells in the battery management apparatus is {2, 3, 2, 3, 1, 6, 3, 3}. By comparing the target equivalent self-discharge values of all cells, it is determined that the minimum target equivalent self-discharge value is 1, and the maximum target equivalent self-discharge value is 6. A value of the interval is preset to 2, the maximum target equivalent self-discharge value is divided by the interval to obtain a maximum equivalent self-discharge rate (3), and the minimum target equivalent self-discharge value is divided by the interval to obtain a minimum equivalent self-discharge rate (0.5). When it is determined that a difference (2.5) between the maximum equivalent self-discharge rate and the minimum equivalent self-discharge rate is greater than a preset threshold (preset to 2), a target cell corresponding to the maximum target equivalent self-discharge value is managed, that is, a cell with a target equivalent self-discharge value of 6 is managed.

In the battery management method provided in this embodiment of the present invention, by obtaining the current high-voltage inflection point power value of the charging curve of each cell and the current historical cumulative balance power value, the current equivalent self-discharge value of each cell is obtained. The target equivalent self-discharge value of each cell is obtained by subtracting the equivalent self-discharge value at the previous moment from the current equivalent self-discharge value, so that self-discharge conditions of all cells are monitored during the use of the battery management apparatus. Then the maximum equivalent self-discharge rate and the minimum equivalent self-discharge rate are obtained through calculation by using the target equivalent self-discharge values of all cells, and when the difference between the maximum equivalent self-discharge rate and the minimum equivalent self-discharge rate is greater than the preset threshold, the target cell with the maximum equivalent self-discharge rate is managed, so that a user can promptly discover a cell with abnormal self-discharge to perform maintenance or replacement.

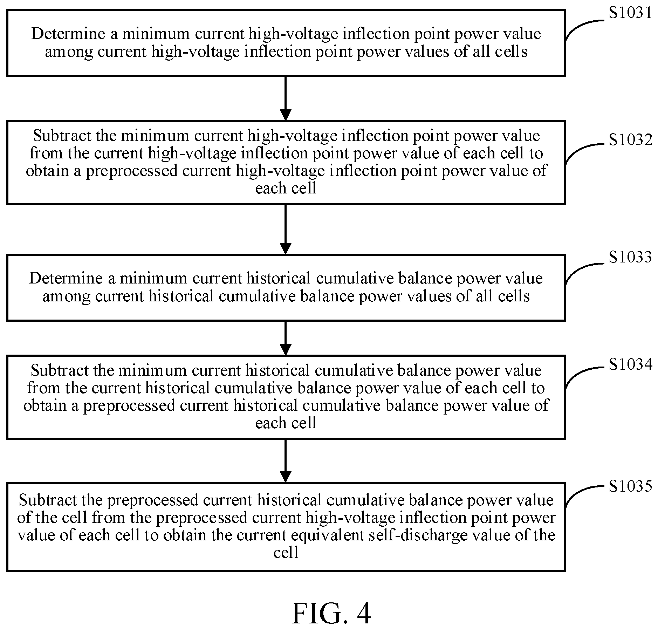

Refer to FIG. 4. FIG. 4 is a sub-flowchart of step S103 in FIG. 1. In some embodiments, as shown in FIG. 4, that the current equivalent self-discharge value of the cell is obtained according to the current high-voltage inflection point power value of each cell and the current historical cumulative balance power value of the cell includes:
S1031: A minimum current high-voltage inflection point power value among the current high-voltage inflection point power values of all cells is determined.
S1032: The minimum current high-voltage inflection point power value is subtracted from the current high-voltage inflection point power value of each cell to obtain a preprocessed current high-voltage inflection point power value of each cell.
S1033: A minimum current historical cumulative balance power value among the current historical cumulative balance power values of all cells is determined.
S1034: The minimum current historical cumulative balance power value is subtracted from the current historical cumulative balance power value of each cell to obtain a preprocessed current historical cumulative balance power value of each cell.
S1035: The preprocessed current historical cumulative balance power value of the cell is subtracted from the preprocessed current high-voltage inflection point power value of each cell to obtain the current equivalent self-discharge value of the cell.

When the minimum current high-voltage inflection point power value among the current high-voltage inflection point power values of all cells is determined, the obtained current high-voltage inflection point power values of all cells are compared to determine the minimum current high-voltage inflection point power value.

When the minimum current historical cumulative balance power value among the current historical cumulative balance power values of all cells is determined, the obtained current historical cumulative balance power values of all cells are compared to determine the minimum current historical cumulative balance power value.

Steps S1031 to S1035 are further described in detail below by taking a battery management apparatus including eight cells as an example.

A set of the current high-voltage inflection point power values of all cells in the battery management apparatus is {4, 6, 8, 5, 1, 7, 5, 3}. By comparing the current high-voltage inflection point power values of all cells, it is determined that the minimum current high-voltage inflection point power value is 1; the minimum current high-voltage inflection point power value is subtracted from the current high-voltage inflection point power value of each cell to obtain a preprocessed current high-voltage inflection point power value of each cell, so that a set of preprocessed current high-voltage inflection point power values of all cells {3, 5, 7, 4, 0, 6, 4, 2} may be obtained; a set of the current historical cumulative balance power values of all cells in the battery management apparatus is {2, 4, 5, 6, 3, 4, 5, 3}. By comparing the current historical cumulative balance power values of all cells, it is determined that the minimum current historical cumulative balance power value is 2; the minimum current historical cumulative balance power value is subtracted from the current historical cumulative balance power value of each cell to obtain a preprocessed current historical cumulative balance power value of each cell, so that a set of the preprocessed current historical cumulative balance power values of all cells {0, 2, 3, 4, 1, 2, 3, 1} may be obtained; and the preprocessed current historical cumulative balance power value of the cell is subtracted from the preprocessed current high-voltage inflection point power value of each cell to obtain the current equivalent self-discharge value of the cell, so that a set of the current equivalent self-discharge values of all cells {3, 2, 4, 0, -1, 4, 1, 1} may be obtained.

Therefore, in some embodiments, preprocessing is performed such as normalizing the current high-voltage inflection point power values of all cells and normalizing the current historical cumulative balance power values of all cells, that is, the minimum current high-voltage inflection point power value is subtracted from the current high-voltage inflection point power value of each cell to obtain the preprocessed current high-voltage inflection point power value of each cell and the minimum current historical cumulative balance power value is subtracted from the current historical cumulative balance power value of each cell to obtain the preprocessed current historical cumulative balance power value of each cell, and then the preprocessed current historical cumulative balance power value is subtracted from the preprocessed current high-voltage inflection point power value to obtain the current equivalent self-discharge value, so that the space required to store the current equivalent self-discharge value may be reduced, and the requirements for the memory may be reduced, thereby saving the cost.

In some other embodiments, that the current equivalent self-discharge value of the cell is obtained according to the current high-voltage inflection point power value of each cell and the current historical cumulative balance power value of the cell includes: the current historical cumulative balance power value of the cell is subtracted from the current high-voltage inflection point power value of each cell to obtain the current equivalent self-discharge value of the cell. That is, in another embodiment, there is no need to preprocess the current high-voltage inflection point power value and the current historical cumulative balance power value. The current historical cumulative balance power value is directly subtracted from the current high-voltage inflection point power value to obtain the current equivalent self-discharge value, so that a number of operations may be reduced, and battery power is saved.

In some embodiments, the battery management apparatus is applied to a vehicle, and that the target cell corresponding to the maximum target equivalent self-discharge value is managed includes: information about the target cell is sent to the vehicle and/or a terminal that is communicatively connected to the vehicle.

The information about the target cell may include a number, a location, the target equivalent self-discharge value, and an equivalent self-discharge rate of the target cell, and the information about the target cell is sent to the vehicle or/or a terminal in communicatively connected to the vehicle. For example, the terminal is a mobile phone of the user. When the vehicle receives the information, a display of the vehicle is controlled to display the information and send an early warning signal, and/or when the terminal receives the information, the information is displayed and the early warning signal is sent to remind the user to maintain or replace the target cell as soon as possible.

In the battery management method provided in this embodiment of the present invention, when it is determined that a difference between the maximum equivalent self-discharge rate and the minimum equivalent self-discharge rate is greater than a preset threshold, the information about the target cell corresponding to the maximum target equivalent self-discharge value is sent to the vehicle and/or the terminal communicatively connected to the vehicle, so that the user is informed of the information about the cell with abnormal self-discharge and the user is reminded, to allow the user to take timely measures against the abnormal cell.

In some embodiments, the battery management apparatus further includes a plurality of reminder modules, each reminder module corresponds to a cell, and that the target cell corresponding to the maximum target equivalent self-discharge value is managed further includes: a reminder module corresponding to the target cell is controlled to issue an early warning signal. The reminder module corresponding to the target cell is controlled to issue the early warning signal, so that the user may promptly discover the cell with abnormal self-discharge to preform maintenance or replacement.

The reminder module may be a buzzer component, a voice component, a warning light, and the like.

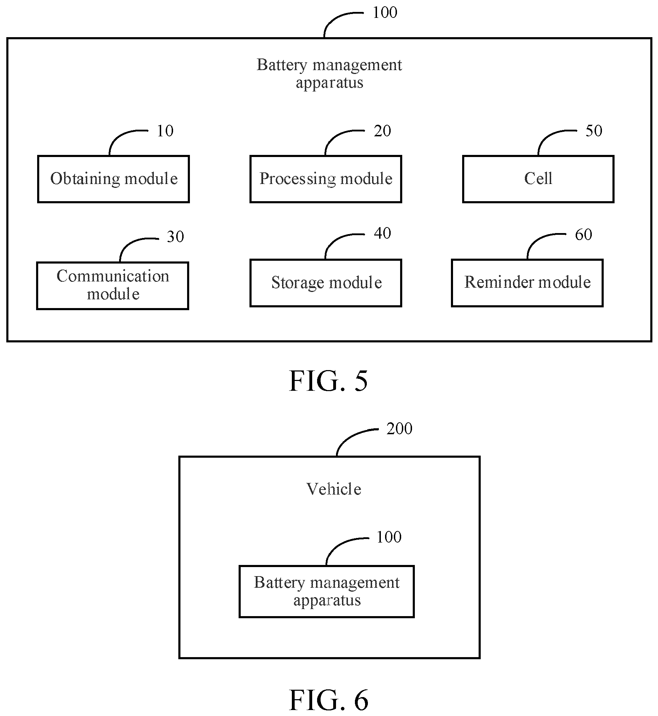

In some embodiments, the battery management method further includes: the equivalent self-discharge value at the previous moment of the cell is replaced with the current equivalent self-discharge value of each cell to update a stored self-discharge value of the cell. The self-discharge value of each cell is stored in a storage module 40 of a battery management apparatus 100 shown in FIG. 5. The equivalent self-discharge value at the previous moment is replaced with the current equivalent self-discharge value for calculation of a target equivalent self-discharge value at a next moment. The next time the target equivalent self-discharge value is calculated, the current equivalent self-discharge value is the foregoing equivalent self-discharge value at the previous moment.

In some embodiments, that the equivalent self-discharge value at the previous moment of the cell is replaced with the current equivalent self-discharge value of each cell to update the stored self-discharge value of the cell includes: a minimum current equivalent self-discharge value among current equivalent self-discharge values of all cells is determined; the minimum current equivalent self-discharge value is subtracted from the current equivalent self-discharge value of each cell to obtain a preprocessed current equivalent self-discharge value of each cell; and the equivalent self-discharge value at the previous moment of the cell is replaced with the preprocessed current equivalent self-discharge value of each cell to update the stored equivalent self-discharge value of the cell. The next time the target equivalent self-discharge value is calculated, the preprocessed current equivalent self-discharge value is the foregoing equivalent self-discharge value at the previous moment.

The foregoing steps are further described in detail below by taking a battery management apparatus including eight cells as an example.

A set of the current equivalent self-discharge values of all cells in the battery management apparatus is {5, 7, 4, 3, 2, 7, 8, 4}. By comparing the current equivalent self-discharge values of all cells, it is determined that the minimum current equivalent self-discharge value is 2; the minimum current equivalent self-discharge value is subtracted from the current equivalent self-discharge value of each cell to obtain a preprocessed current equivalent self-discharge value of each cell, so that an obtained set of the preprocessed current equivalent self-discharge values of all cells is {3, 5, 2, 1, 0, 5, 6, 2}; and the set of the equivalent self-discharge values at the previous moment of all cells is replaced with the set of the preprocessed current equivalent self-discharge values of all cells.

In the battery management method provided in this embodiment of the present invention, normalized preprocessing is performed on the current equivalent self-discharge values of all cells, that is, the minimum current equivalent self-discharge value of the cell is subtracted from the current equivalent self-discharge value of each cell to obtain the preprocessed current equivalent self-discharge values of all cells, and then the preprocessed current equivalent self-discharge values of all cells are stored, so that the space required to store the preprocessed current equivalent self-discharge values may be reduced, and the requirements for the memory may be reduced, thereby saving the cost.

Refer to FIG. 5. FIG. 5 is a block diagram of a structure of a battery management apparatus 100 according to an embodiment of the present invention. As shown in FIG. 5, the battery management apparatus 100 includes a number of cells 50, an obtaining module 10, and a processing module 20. The obtaining module 10 is configured to obtain a current high-voltage inflection point power value corresponding to a high-voltage inflection point of a charging curve of each cell 50 at a current moment, a current historical cumulative balance power value of each cell 50 at the current moment, and an equivalent self-discharge value at a previous moment of each cell 50. The processing module 20 is configured to obtain a current equivalent self-discharge value of the cell 50 according to the current high-voltage inflection point power value of each cell 50 and the current historical cumulative balance power value of the cell 50; subtract the equivalent self-discharge value at the previous moment of the cell 50 from the current equivalent self-discharge value of each cell 50 to obtain a target equivalent self-discharge value of the cell 50 within an interval between the current moment and the previous moment; determine a maximum target equivalent self-discharge value and a minimum target equivalent self-discharge value among the target equivalent self-discharge values of all cells 50; divide the maximum target equivalent self-discharge value by the interval to obtain a maximum equivalent self-discharge rate, and divide the minimum target equivalent self-discharge value by the interval to obtain a minimum equivalent self-discharge rate; and when it is determined that a difference between the maximum equivalent self-discharge rate and the minimum equivalent self-discharge rate is greater than a preset threshold, manage a target cell 50 corresponding to the maximum target equivalent self-discharge value.

In some embodiments, the obtaining module 10 and the processing module 20 may be processing chips such as a processor, a microcontroller, a controller, and the like, and the obtaining module 10 and the processing module 20 may be separate processing chips or an integrated processing chip.

In the battery management apparatus 100 provided in this embodiment of the present invention, by obtaining the current high-voltage inflection point power value of the charging curve of each cell 50 and the current historical cumulative balance power value, the current equivalent self-discharge value of each cell 50 is obtained. The target equivalent self-discharge value of each cell 50 is obtained by subtracting the equivalent self-discharge value at the previous moment from the current equivalent self-discharge value, so that self-discharge conditions of all cells 50 are monitored during the use of the battery management apparatus 100. Then the maximum equivalent self-discharge rate and the minimum equivalent self-discharge rate are obtained through calculation by using the target equivalent self-discharge values of all cells 50, and when the difference between the maximum equivalent self-discharge rate and the minimum equivalent self-discharge rate is greater than the preset threshold, the target cell 50 with the maximum equivalent self-discharge rate is managed, so that a user can promptly discover a cell with abnormal self-discharge to perform maintenance or replacement.

In some embodiments, that the current equivalent self-discharge value of the cell 50 is obtained according to the current high-voltage inflection point power value of each cell 50 and the current historical cumulative balance power value of the cell 50 includes: the processing module 20 determines a minimum current high-voltage inflection point power value among current high-voltage inflection point power values of all cells 50; subtracts the minimum current high-voltage inflection point power value from the current high-voltage inflection point power value of each cell 50 to obtain a preprocessed current high-voltage inflection point power value of each cell 50; determines a minimum current historical cumulative balance power value among current historical cumulative balance power values of all cells 50; subtracts the minimum current historical cumulative balance power value from the current historical cumulative balance power value of each cell 50 to obtain a preprocessed current historical cumulative balance power value of each cell 50; and subtracts the preprocessed current historical cumulative balance power value of the cell 50 from the preprocessed current high-voltage inflection point power value of each cell 50 to obtain the current equivalent self-discharge value of the cell 50.

The battery management apparatus 100 provided in the embodiments of the present invention performs preprocessing such as normalizing the current high-voltage inflection point power values of all cells 50 and normalizing the current historical cumulative balance power values of all cells 50, that is, the minimum current high-voltage inflection point power value is subtracted from the current high-voltage inflection point power value of each cell 50 to obtain a preprocessed current high-voltage inflection point power value of each cell 50; the minimum current historical cumulative balance power value is subtracted from the current historical cumulative balance power value of each cell 50 to obtain a preprocessed current historical cumulative balance power value of each cell 50; and then the preprocessed current historical cumulative balance power value is subtracted from the preprocessed current high-voltage inflection point power value to obtain the current equivalent self-discharge value, so that the space required to store the current equivalent self-discharge value may be reduced, and the requirements for the memory may be reduced, thereby saving the cost.

In some other embodiments, that the current equivalent self-discharge value of the cell 50 is obtained according to the current high-voltage inflection point power value of each cell 50 and the current historical cumulative balance power value of the cell 50 includes: the processing module 20 subtracts the current historical cumulative balance power value of the cell 50 from the current high-voltage inflection point power value of each cell 50 to obtain the current equivalent self-discharge value of the cell 50. That is, in another embodiment, there is no need to preprocess the current high-voltage inflection point power value and the current historical cumulative balance power value. The current historical cumulative balance power value is directly subtracted from the current high-voltage inflection point power value to obtain the current equivalent self-discharge value, so that a number of operations may be reduced, and battery power is saved.

In some embodiments, the battery management apparatus 100 is applied to a vehicle. As shown in FIG. 5, the battery management apparatus 100 further includes a communication module 30 configured to communicate with the vehicle, and the managing a target cell 50 corresponding to the maximum target equivalent self-discharge value includes: through the communication module 30, information about the target cell 50 is sent to the vehicle and/or a terminal that is communicatively connected to the vehicle.

The battery management apparatus 100 may send the number, the location, the target equivalent self-discharge value, and the equivalent self-discharge rate of the target cell 50 to the vehicle and/or the terminal communicatively connected to the vehicle through the communication module 30, so that the user may promptly discover the cell with abnormal self-discharge and maintain or replace it.

In some embodiments, the battery management apparatus 100 further includes a number of reminder modules 60, each reminder module 60 corresponds to a cell 50, and the managing a target cell 50 corresponding to the maximum target equivalent self-discharge value includes: a reminder module 60 corresponding to the target cell 50 is controlled to issue an early warning signal.

In some embodiments, the reminder module 60 may be a buzzer component, a voice component, a warning light, and the like.

When it is determined that a difference between the maximum equivalent self-discharge rate and the minimum equivalent self-discharge rate is greater than a preset threshold, the processing module 20 determines the target cell 50 corresponding to the maximum equivalent self-discharge rate and controls the reminder module 60 corresponding to the target cell 50 to issue the early warning signal. Exemplarily, the number of cells are numbered in advance, and the number of reminder modules 60 have numbers corresponding to the numbers of the number of cells. When the difference between the maximum equivalent self-discharge rate and the minimum equivalent self-discharge rate is greater than a preset threshold, the processing module 20 determines the number of the target cell 50 and controls the reminder module 60 with the same number of the target cell 50 to issue the early warning signal, for example, a buzzer, a voice broadcast, a warning light flashing, and the like to remind the user that the self-discharge abnormality occurs in the cell and inform the user of the number of the cell with abnormal self-discharge, so that the user may identify the location of the cell with abnormal self-discharge and maintain or replace it in time.

In some embodiments, as shown in FIG. 5, the battery management apparatus 100 further includes a storage module 40. The storage module 40 stores a self-discharge value of each cell 50. The processing module 20 is further configured to replace the equivalent self-discharge value at the previous moment of the cell 50 with the current equivalent self-discharge value of each cell 50 to update the self-discharge value of the cell 50 stored in the storage module 40 for calculation of the target equivalent self-discharge value at the next moment. The next time the target equivalent self-discharge value is calculated, the current equivalent self-discharge value is the foregoing equivalent self-discharge value at the previous moment.

In some embodiments, the replacing the equivalent self-discharge value at the previous moment of the cell 50 with the current equivalent self-discharge value of each cell 50 to update the self-discharge value of the cell 50 stored in the storage module 40 includes: a minimum current equivalent self-discharge value among current equivalent self-discharge values of all cells is determined; the minimum current equivalent self-discharge value is subtracted from the current equivalent self-discharge value of each cell 50 to obtain a preprocessed current equivalent self-discharge value of each cell 50; and the equivalent self-discharge value at the previous moment of the cell 50 is replaced with the preprocessed current equivalent self-discharge value of each cell 50 to update the stored equivalent self-discharge value of the cell 50. The next time the target equivalent self-discharge value is calculated, the preprocessed current equivalent self-discharge value is the foregoing equivalent self-discharge value at the previous moment.

In some embodiments, the storage module 40 further stores the charging curve of each cell 50 at the current moment and the current high-voltage inflection point power value, so that the obtaining module 10 may obtain the current high-voltage inflection point power value of each cell 50 at the current moment.

In some embodiments, the storage module 40 further stores the current historical cumulative balance power value of each cell 50 at the current moment, so that the obtaining module 10 may obtain the current high-voltage inflection point power value of each cell 50 at the current moment.

The storage module 40 may be a non-volatile memory, such as an FRAM (Ferroelectric Random Access Memory), an EEPROM (Electrically Erasable Programmable Read Only Memory), an EPROM (Erasable Programmable Read Only Memory), and the like.

In the battery management apparatus 100 provided in this embodiment of the present invention, normalized preprocessing is performed on the current equivalent self-discharge values of all cells 50, that is, the minimum current equivalent self-discharge value of the cell 50 is subtracted from the current equivalent self-discharge value of each cell 50 to obtain a preprocessed current equivalent self-discharge value of each cell 50, and then the preprocessed current equivalent self-discharge values of all cells 50 are stored, so that the space required to store the preprocessed current equivalent self-discharge values may be reduced, and the requirements for the memory may be reduced, thereby saving the cost.

The battery management apparatus 100 corresponds to the foregoing battery management method. For a more detailed description, reference may be made to the content of each embodiment of the foregoing battery management method. The contents of the battery management apparatus 100 and the foregoing battery management method may also be referred to each other.

Refer to FIG. 6, FIG. 6 is a block diagram of a structure of a vehicle 200 according to an embodiment of the present invention. As shown in FIG. 6, the vehicle 200 includes the battery management apparatus 100 provided in any of the foregoing embodiments.

The vehicle 200 may be a pure electric vehicle, a hybrid vehicle, and the like, such as a pure electric vehicle, a pure electric truck, a hybrid truck, and the like.

An embodiment of the present invention further provides a computer-readable storage medium. The computer-readable storage medium stores a computer program, and the computer program is invoked by a processor to perform the foregoing battery management method provided in any of the foregoing embodiments.

A person of ordinary skill in the art may understand that all or some of the steps of the various methods in the foregoing embodiments may be implemented by a program instructing relevant hardware. The program may be stored in a computer-readable member. The storage member may include: a flash disk, a read-only memory, a random access device, a magnetic disk, an optical disk, or the like.

It should be noted that for ease of description, the foregoing method embodiments are described as a series of action combinations. However, persons skilled in the art should know that the present invention is not limited to the described order of the actions because some steps may be performed in another order or performed at the same time according to the present invention. In addition, a person skilled in the art is also to learn that the embodiments described in this specification are all exemplary embodiments.

In the foregoing embodiments, the descriptions of each embodiment have different focuses, and for a part that is not described in detail in an embodiment, reference may be made to the relevant description of other embodiments.

It should be noted that the foregoing descriptions are merely preferred embodiments of the present invention, and a person of ordinary skill in the art may make various improvements and modifications without departing from the scope of the present invention as defined in the appended claims. All such improvements and refinements shall fall within the protection scope of the present invention as defined in the appended claims.

Reference Numerals: 100-battery management apparatus; 10-obtaining module; 20-processing module; 30-communication module; 40-storage module; 200-vehicle; 50-cell; and 60-reminder module.

## Claims

1. A battery management method, applied to a battery management apparatus, the battery management apparatus comprising a plurality of cells, and the battery management method comprising the following steps:
obtaining a current high-voltage inflection point power value corresponding to a high-voltage inflection point of a charging curve of each cell at a current moment (S101); the method **characterised by**:
obtaining a current historical cumulative balance power value of each cell at the current moment (S102);
obtaining a current equivalent self-discharge value of the cell according to the current high-voltage inflection point power value of each cell and the current historical cumulative balance power value of the cell (S103);
obtaining an equivalent self-discharge value at a previous moment of each cell (S104);
subtracting the equivalent self-discharge value at the previous moment of the cell from the current equivalent self-discharge value of each cell to obtain a target equivalent self-discharge value of the cell within an interval between the current moment and the previous moment (S105);
determining a maximum target equivalent self-discharge value and a minimum target equivalent self-discharge value among the target equivalent self-discharge values of all cells (S106);
dividing the maximum target equivalent self-discharge value by the interval to obtain a maximum equivalent self-discharge rate, and dividing the minimum target equivalent self-discharge value by the interval to obtain a minimum equivalent self-discharge rate (S107); and
when it is determined that a difference between the maximum equivalent self-discharge rate and the minimum equivalent self-discharge rate is greater than a preset threshold, managing a target cell corresponding to the maximum target equivalent self-discharge value (S108).

2. The battery management method according to claim 1, the obtaining a current equivalent self-discharge value of the cell according to the current high-voltage inflection point power value of each cell and the current historical cumulative balance power value of the cell comprising:
subtracting the current historical cumulative balance power value of the cell from the current high-voltage inflection point power value of each cell to obtain the current equivalent self-discharge value of the cell.

3. The battery management method according to claim 1, the obtaining a current equivalent self-discharge value of the cell according to the current high-voltage inflection point power value of each cell and the current historical cumulative balance power value of the cell comprising:
determining a minimum current high-voltage inflection point power value among current high-voltage inflection point power values of all cells (S1031);
subtracting the minimum current high-voltage inflection point power value from the current high-voltage inflection point power value of each cell to obtain a preprocessed current high-voltage inflection point power value of each cell (S1032);
determining a minimum current historical cumulative balance power value among current historical cumulative balance power values of all cells (S1033);
subtracting the minimum current historical cumulative balance power value from the current historical cumulative balance power value of each cell to obtain a preprocessed current historical cumulative balance power value of each cell (S1034); and
subtracting the preprocessed current historical cumulative balance power value of the cell from the preprocessed current high-voltage inflection point power value of each cell to obtain the current equivalent self-discharge value of the cell (S1035).

4. The battery management method according to any one of claims 1 to 3, the battery management apparatus being applied to a vehicle, and the managing a target cell corresponding to the maximum target equivalent self-discharge value comprising:
sending information about the target cell to the vehicle and/or a terminal that is communicatively connected to the vehicle;
particularly wherein the information about the target cell comprises a number, a location, the target equivalent self-discharge value, and an equivalent self-discharge rate of the target cell.

5. The battery management method according to any one of claims 1 to 4, wherein the battery management apparatus further comprises a plurality of reminder modules, each reminder module corresponds to a cell, and the managing a target cell corresponding to the maximum target equivalent self-discharge value further comprises:
controlling a reminder module corresponding to the target cell to issue an early warning signal.

6. The battery management method according to any one of claims 1 to 5, further comprising:
replacing the equivalent self-discharge value at the previous moment of the cell with the current equivalent self-discharge value of each cell to update a stored equivalent self-discharge value of the cell;
particularly wherein the replacing the equivalent self-discharge value at the previous moment of the cell with the current equivalent self-discharge value of each cell to update a stored equivalent self-discharge value of the cell comprises:
determining a minimum current equivalent self-discharge value among current equivalent self-discharge values of all cells;
subtracting the minimum current equivalent self-discharge value from the current equivalent self-discharge value of each cell to obtain a preprocessed current equivalent self-discharge value of each cell; and
replacing the equivalent self-discharge value at the previous moment of the cell with the preprocessed current equivalent self-discharge value of each cell to update the stored equivalent self-discharge value of the cell.

7. The battery management method according to any one of claims 1 to 6, wherein the previous moment is a moment at which the vehicle leaves a factory, the equivalent self-discharge value at the previous moment of each cell is 0, the historical cumulative balance power value at the previous moment of each cell is 0, and the high-voltage inflection point power value at the previous moment of each cell is 0; or
wherein when the current moment is current charging, a moment of the charging curve is obtained, and when the previous moment is previous charging, a moment of the charging curve is obtained.

8. The battery management method according to any one of claims 1 to 7, wherein the cell is a power battery or an energy storage battery.

9. A battery management apparatus (100), the battery management apparatus comprising a plurality of cells (50), and further comprising:
an obtaining module (10), configured to obtain a current high-voltage inflection point power value corresponding to a high-voltage inflection point of a charging curve of each cell at a current moment, a current historical cumulative balance power value of each cell at the current moment, and an equivalent self-discharge value at a previous moment of each cell; and
a processing module (20), configured to obtain a current equivalent self-discharge value of the cell according to the current high-voltage inflection point power value of each cell and the current historical cumulative balance power value of the cell; subtract the equivalent self-discharge value at the previous moment of the cell from the current equivalent self-discharge value of each cell to obtain a target equivalent self-discharge value of the cell within an interval between the current moment and the previous moment; determine a maximum target equivalent self-discharge value and a minimum target equivalent self-discharge value among the target equivalent self-discharge values of all cells; divide the maximum target equivalent self-discharge value by the interval to obtain a maximum equivalent self-discharge rate, and divide the minimum target equivalent self-discharge value by the interval to obtain a minimum equivalent self-discharge rate; and when it is determined that a difference between the maximum equivalent self-discharge rate and the minimum equivalent self-discharge rate is greater than a preset threshold, manage a target cell corresponding to the maximum target equivalent self-discharge value.

10. The battery management apparatus according to claim 9, when configured to obtain a current equivalent self-discharge value of the cell according to the current high-voltage inflection point power value of each cell and the current historical cumulative balance power value of the cell, the processing module (20) being specifically configured to:
subtract the current historical cumulative balance power value of the cell from the current high-voltage inflection point power value of each cell to obtain the current equivalent self-discharge value of the cell; or
when configured to obtain a current equivalent self-discharge value of the cell according to the current high-voltage inflection point power value of each cell and the current historical cumulative balance power value of the cell, the processing module (20) being specifically configured to:
determine a minimum current high-voltage inflection point power value among current high-voltage inflection point power values of all cells;
subtract the minimum current high-voltage inflection point power value from the current high-voltage inflection point power value of each cell to obtain a preprocessed current high-voltage inflection point power value of each cell;
determine a minimum current historical cumulative balance power value among current historical cumulative balance power values of all cells;
subtract the minimum current historical cumulative balance power value from the current historical cumulative balance power value of each cell to obtain a preprocessed current historical cumulative balance power value of each cell; and
subtract the preprocessed current historical cumulative balance power value of the cell from the preprocessed current high-voltage inflection point power value of each cell to obtain the current equivalent self-discharge value of the cell.

11. The battery management apparatus according to any one of claims 9 to 10, the battery management apparatus being applied to a vehicle, the battery management apparatus further comprising a communication module (30) configured to communicate with the vehicle, and when configured to manage a target cell corresponding to the maximum target equivalent self-discharge value, the processing module (20) being specifically configured to:
send, through the communication module (30), information about the target cell to the vehicle and/or a terminal that is communicatively connected to the vehicle.

12. The battery management apparatus according to any of claims 9 to 11, further comprising a plurality of reminder modules (60), each reminder module (60) corresponding to a cell (50), and when configured to manage a target cell corresponding to the maximum target equivalent self-discharge value, the processing module (20) being specifically configured to:
control the reminder module (60) corresponding to the target cell to issue an early warning signal.

13. The battery management apparatus according to any of claims 9 to 12, further comprising a storage module (40), the storage module (40) storing the equivalent self-discharge value of each cell, and the processing module (20) being further configured to replace the equivalent self-discharge value at the previous moment of the cell with the current equivalent self-discharge value of each cell to update a stored self-discharge value of the cell;
particularly wherein, when configured to replace the equivalent self-discharge value at the previous moment of the cell with the current equivalent self-discharge value of each cell to update a stored equivalent self-discharge value of the cell, the processing module (20) is specifically configured to:
determine a minimum current equivalent self-discharge value among current equivalent self-discharge values of all cells;
subtract the minimum current equivalent self-discharge value from the current equivalent self-discharge value of each cell to obtain a preprocessed current equivalent self-discharge value of each cell; and
replace the equivalent self-discharge value at the previous moment of the cell with the preprocessed current equivalent self-discharge value of each cell to update the stored equivalent self-discharge value of the cell.

14. A computer-readable storage medium, storing a computer program, the computer program being invoked by a processor to perform the following steps:
obtaining a current high-voltage inflection point power value corresponding to a high-voltage inflection point of a charging curve of each cell among a plurality of cells at a current moment;
**characterised by**:
obtaining a current historical cumulative balance power value of each cell at the current moment;
obtaining a current equivalent self-discharge value of the cell according to the current high-voltage inflection point power value of each cell and the current historical cumulative balance power value of the cell;
obtaining an equivalent self-discharge value at a previous moment of each cell;
subtracting the equivalent self-discharge value at the previous moment of the cell from the current equivalent self-discharge value of each cell to obtain a target equivalent self-discharge value of the cell within an interval between the current moment and the previous moment;
determining a maximum target equivalent self-discharge value and a minimum target equivalent self-discharge value among the target equivalent self-discharge values of all cells;
dividing the maximum target equivalent self-discharge value by the interval to obtain a maximum equivalent self-discharge rate, and dividing the minimum target equivalent self-discharge value by the interval to obtain a minimum equivalent self-discharge rate; and
when it is determined that a difference between the maximum equivalent self-discharge rate and the minimum equivalent self-discharge rate is greater than a preset threshold, managing a target cell corresponding to the maximum target equivalent self-discharge value.

15. The computer-readable storage medium according to claim 19, in terms of obtaining, according to the current high-voltage inflection point power value of each cell and the current historical cumulative balance power value of the cell, a current equivalent self-discharge value of the cell, the computer program being invoked by the processor to perform the following steps:
determining a minimum current high-voltage inflection point power value among current high-voltage inflection point power values of all cells;
subtracting the minimum current high-voltage inflection point power value from the current high-voltage inflection point power value of each cell to obtain a preprocessed current high-voltage inflection point power value of each cell;
determining a minimum current historical cumulative balance power value among current historical cumulative balance power values of all cells;
subtracting the minimum current historical cumulative balance power value from the current historical cumulative balance power value of each cell to obtain a preprocessed current historical cumulative balance power value of each cell; and
subtracting the preprocessed current historical cumulative balance power value of the cell from the preprocessed current high-voltage inflection point power value of each cell to obtain the current equivalent self-discharge value of the cell.

## Patentansprüche

1. Batteriemanagementverfahren, das auf eine Batteriemanagementvorrichtung angewendet wird, wobei die Batteriemanagementvorrichtung eine Vielzahl von Zellen umfasst und das Batteriemanagementverfahren die folgenden Schritte umfasst:
Ermitteln eines aktuellen Hochspannungs-Wendepunkt-Leistungswerts, der einem Hochspannungs-Wendepunkt einer Ladekurve jeder Zelle zu einem aktuellen Zeitpunkt entspricht (S101); wobei das Verfahren **gekennzeichnet ist durch**:
Ermitteln eines aktuellen historischen kumulativen Ausgleichsleistungswerts jeder Zelle zum aktuellen Zeitpunkt (S102);
Ermitteln eines aktuellen äquivalenten Selbstentladungswerts der Zelle gemäß dem aktuellen Hochspannungs-Wendepunkt-Leistungswert jeder Zelle und dem aktuellen historischen kumulativen Ausgleichsleistungswert der Zelle (S103);
Ermitteln eines äquivalenten Selbstentladungswerts zu einem früheren Zeitpunkt jeder Zelle (S104);
Subtrahieren des äquivalenten Selbstentladungswerts zu einem früheren Zeitpunkt der Zelle vom aktuellen äquivalenten Selbstentladungswert jeder Zelle, um einen Zielwert für die äquivalente Selbstentladung der Zelle innerhalb eines Intervalls zwischen dem aktuellen Zeitpunkt und dem früheren Zeitpunkt zu erhalten (S105);
Bestimmen eines maximalen Zieläquivalenzselbstentladungswerts und eines minimalen Zieläquivalenzselbstentladungswerts unter den Zieläquivalenzselbstentladungswerten aller Zellen (S106);
Dividieren des maximalen Zieläquivalenzselbstentladungswerts **durch** das Intervall, um eine maximale Äquivalenzselbstentladungsrate zu erhalten, und Dividieren des minimalen Zieläquivalenzselbstentladungswerts **durch** das Intervall, um eine minimale Äquivalenzselbstentladungsrate zu erhalten (S107); und
wenn festgestellt wird, dass eine Differenz zwischen der maximalen Äquivalenzselbstentladungsrate und der minimalen Äquivalenzselbstentladungsrate größer als ein voreingestellter Schwellenwert ist, Verwalten einer Zielzelle, die dem maximalen Zieläquivalenzselbstentladungswert entspricht (S108).

2. Batteriemanagementverfahren gemäß Anspruch 1, wobei das Ermitteln eines aktuellen äquivalenten Selbstentladungswerts der Zelle gemäß dem aktuellen Hochspannungs-Wendepunkt-Leistungswert jeder Zelle und dem aktuellen historischen kumulativen Ausgleichsleistungswert der Zelle umfasst:
Subtrahieren des aktuellen historischen kumulativen Ausgleichsleistungswerts der Zelle vom aktuellen Hochspannungs-Wendepunkt-Leistungswert jeder Zelle, um den aktuellen äquivalenten Selbstentladungswert der Zelle zu erhalten.

3. Batteriemanagementverfahren gemäß Anspruch **1,** wobei das Ermitteln eines aktuellen äquivalenten Selbstentladungswerts der Zelle gemäß dem aktuellen Hochspannungs-Wendepunkt-Leistungswert jeder Zelle und dem aktuellen historischen kumulativen Ausgleichsleistungswert der Zelle umfasst:
Bestimmen eines minimalen aktuellen Hochspannungs-Wendepunkt-Leistungswerts unter den aktuellen Hochspannungs-Wendepunkt-Leistungswerten aller Zellen (S 1031);
Subtrahieren des minimalen aktuellen Hochspannungs-Wendepunkt-Leistungswerts vom aktuellen Hochspannungs-Wendepunkt-Leistungswert jeder Zelle, um einen vorverarbeiteten aktuellen Hochspannungs-Wendepunkt-Leistungswert jeder Zelle zu erhalten (S 1032);
Bestimmen eines minimalen aktuellen historischen kumulativen Ausgleichsleistungswerts unter den aktuellen historischen kumulativen Ausgleichsleistungswerten aller Zellen (S1033);
Subtrahieren des minimalen aktuellen historischen kumulativen Ausgleichsleistungswerts vom aktuellen historischen kumulativen Ausgleichsleistungswert jeder Zelle, um einen vorverarbeiteten aktuellen historischen kumulativen Ausgleichsleistungswert jeder Zelle zu erhalten (S1034); und
Subtrahieren des vorverarbeiteten aktuellen historischen kumulativen Ausgleichsleistungswerts der Zelle vom vorverarbeiteten aktuellen Hochspannungs-Wendepunkt-Leistungswert jeder Zelle, um den aktuellen äquivalenten Selbstentladungswert der Zelle zu erhalten (S1035).

4. Batteriemanagementverfahren gemäß einem der Ansprüche 1 bis 3, wobei die Batteriemanagementvorrichtung in einem Fahrzeug angewendet wird und das Verwalten einer Zielzelle, die dem maximalen Zieläquivalenzselbstentladungswert entspricht, umfasst:
Senden von Informationen über die Zielzelle an das Fahrzeug und/oder ein Terminal, das mit dem Fahrzeug in Verbindung steht;
wobei die Informationen über die Zielzelle insbesondere eine Nummer, einen Standort, den Zieläquivalenzselbstentladungswert und eine Äquivalenzselbstentladungsrate der Zielzelle umfassen.

5. Batteriemanagementverfahren gemäß einem der Ansprüche 1 bis 4, wobei die Batteriemanagementvorrichtung ferner eine Vielzahl von Erinnerungsmodulen umfasst, wobei jedes Erinnerungsmodul einer Zelle entspricht, und das Verwalten einer Zielzelle, die dem maximalen Zieläquivalent-Selbstentladungswert entspricht, ferner umfasst:
Steuern eines der Zielzelle entsprechenden Erinnerungsmoduls, um ein Frühwarnsignal auszugeben.

6. Batteriemanagementverfahren gemäß einem der Ansprüche 1 bis 5, das ferner umfasst: Ersetzen des äquivalenten Selbstentladungswerts zum vorherigen Zeitpunkt der Zelle durch den aktuellen äquivalenten Selbstentladungswert jeder Zelle, um einen gespeicherten äquivalenten Selbstentladungswert der Zelle zu aktualisieren;
wobei insbesondere das Ersetzen des äquivalenten Selbstentladungswerts zum vorherigen Zeitpunkt der Zelle durch den aktuellen äquivalenten Selbstentladungswert jeder Zelle zum Aktualisieren eines gespeicherten äquivalenten Selbstentladungswerts der Zelle umfasst:
Bestimmen eines minimalen aktuellen äquivalenten Selbstentladungswerts unter den aktuellen äquivalenten Selbstentladungswerten aller Zellen;
Subtrahieren des minimalen aktuellen äquivalenten Selbstentladungswerts vom aktuellen äquivalenten Selbstentladungswert jeder Zelle, um einen vorverarbeiteten aktuellen äquivalenten Selbstentladungswert jeder Zelle zu erhalten; und
Ersetzen des äquivalenten Selbstentladungswerts zum vorherigen Zeitpunkt der Zelle durch den vorverarbeiteten aktuellen äquivalenten Selbstentladungswert jeder Zelle, um den gespeicherten äquivalenten Selbstentladungswert der Zelle zu aktualisieren.

7. Batteriemanagementverfahren gemäß einem der Ansprüche 1 bis 6, wobei der vorherige Zeitpunkt ein Zeitpunkt ist, zu dem das Fahrzeug ein Werk verlässt, der äquivalente Selbstentladungswert zum vorherigen Zeitpunkt jeder Zelle 0 ist, der historische kumulative Ausgleichsenergiewert zum vorherigen Zeitpunkt jeder Zelle 0 ist und der Hochspannungs-Wendepunkt-Energiewert zum vorherigen Zeitpunkt jeder Zelle 0 ist; oder
wobei, wenn der aktuelle Moment der aktuelle Ladevorgang ist, ein Moment der Ladekurve erhalten wird, und wenn der vorherige Moment der vorherige Ladevorgang ist, ein Moment der Ladekurve erhalten wird.

8. Batteriemanagementverfahren gemäß einem der Ansprüche 1 bis 7, wobei die Zelle eine Leistungsbatterie oder eine Energiespeicherbatterie ist.

9. Batteriemanagementvorrichtung (100), wobei die Batteriemanagementvorrichtung eine Vielzahl von Zellen (50) umfasst und ferner umfasst:
ein Erfassungsmodul (10), das dazu konfiguriert ist, einen aktuellen Hochspannungs-Wendepunkt-Leistungswert, der einem Hochspannungs-Wendepunkt einer Ladekurve jeder Zelle zu einem aktuellen Zeitpunkt entspricht, einen aktuellen historischen kumulativen Ausgleichsleistungswert jeder Zelle zu einem aktuellen Zeitpunkt und einen äquivalenten Selbstentladungswert zu einem vorherigen Zeitpunkt jeder Zelle zu erfassen; und
ein Verarbeitungsmodul (20), das dazu konfiguriert ist, einen aktuellen äquivalenten Selbstentladungswert der Zelle gemäß dem aktuellen Hochspannungs-Wendepunkt-Leistungswert jeder Zelle und dem aktuellen historischen kumulativen Ausgleichsleistungswert der Zelle zu erhalten; Subtrahieren des äquivalenten Selbstentladungswerts zum vorherigen Zeitpunkt der Zelle vom aktuellen äquivalenten Selbstentladungswert jeder Zelle, um einen Zieläquivalent-Selbstentladungswert der Zelle innerhalb eines Intervalls zwischen dem aktuellen Zeitpunkt und dem vorherigen Zeitpunkt zu erhalten; Bestimmen eines maximalen Zieläquivalent-Selbstentladungswerts und eines minimalen Zieläquivalent-Selbstentladungswerts unter den Zieläquivalent-Selbstentladungswerten aller Zellen; Teilen des maximalen Zieläquivalenzselbstentladungswerts durch das Intervall, um eine maximale Äquivalenzselbstentladungsrate zu erhalten, und Teilen des minimalen Zieläquivalenzselbstentladungswerts durch das Intervall, um eine minimale Äquivalenzselbstentladungsrate zu erhalten. und wenn festgestellt wird, dass eine Differenz zwischen der maximalen äquivalenten Selbstentladungsrate und der minimalen äquivalenten Selbstentladungsrate größer als ein voreingestellter Schwellenwert ist, Verwalten einer Zielzelle, die dem maximalen Zieläquivalent-Selbstentladungswert entspricht.

10. Batterieverwaltungsvorrichtung gemäß Anspruch 9, die dazu konfiguriert ist, einen aktuellen äquivalenten Selbstentladungswert der Zelle gemäß dem aktuellen Hochspannungs-Wendepunkt-Leistungswert jeder Zelle und dem aktuellen historischen kumulativen Ausgleichsleistungswert der Zelle zu ermitteln, wobei das Verarbeitungsmodul (20) spezifisch so konfiguriert ist, um :
den aktuellen historischen kumulativen Ausgleichsleistungswert der Zelle vom aktuellen Hochspannungs-Wendepunkt-Leistungswert jeder Zelle zu subtrahieren, um den aktuellen äquivalenten Selbstentladungswert der Zelle zu erhalten; oder
wenn es dazu konfiguriert ist, dass es einen aktuellen äquivalenten Selbstentladungswert der Zelle gemäß dem aktuellen Hochspannungs-Wendepunkt-Leistungswert jeder Zelle und dem aktuellen historischen kumulativen Ausgleichsleistungswert der Zelle ermittelt, das Verarbeitungsmodul (20) spezifisch konfiguriert ist zu:
Bestimmen eines minimalen aktuellen Hochspannungs-Wendepunkt-Leistungswerts unter den aktuellen Hochspannungs-Wendepunkt-Leistungswerten aller Zellen;
Subtrahieren des minimalen aktuellen Hochspannungs-Wendepunkt-Leistungswerts vom aktuellen Hochspannungs-Wendepunkt-Leistungswert jeder Zelle, um einen vorverarbeiteten aktuellen Hochspannungs-Wendepunkt-Leistungswert jeder Zelle zu erhalten;
Bestimmen eines minimalen aktuellen historischen kumulativen Ausgleichsleistungswerts unter den aktuellen historischen kumulativen Ausgleichsleistungswerten aller Zellen;
Subtrahieren des minimalen aktuellen historischen kumulativen Ausgleichsleistungswerts vom aktuellen historischen kumulativen Ausgleichsleistungswert jeder Zelle, um einen vorverarbeiteten aktuellen historischen kumulativen Ausgleichsleistungswert jeder Zelle zu erhalten; und
Subtrahieren des vorverarbeiteten aktuellen historischen kumulativen Ausgleichsleistungswerts der Zelle vom vorverarbeiteten aktuellen Hochspannungs-Wendepunkt-Leistungswert jeder Zelle, um den aktuellen äquivalenten Selbstentladungswert der Zelle zu erhalten.

11. Batteriemanagementvorrichtung gemäß Anspruch 9 bis 10, wobei die Batteriemanagementvorrichtung in einem Fahrzeug eingesetzt wird und ferner ein Kommunikationsmodul (30) umfasst, das dazu konfiguriert ist, mit dem Fahrzeug zu kommunizieren, und wobei das Verarbeitungsmodul (20), wenn es für die Verwaltung einer Zielzelle entsprechend dem maximalen Zieläquivalentselbstentladungswert konfiguriert ist, spezifisch dafür konfiguriert ist,
über das Kommunikationsmodul (30) Informationen über die Zielzelle an das Fahrzeug und/oder ein mit dem Fahrzeug in Verbindung stehendes Endgerät zu senden.

12. Batteriemanagementvorrichtung gemäß einem der Ansprüche 9 bis 11, die ferner eine Vielzahl von Erinnerungsmodulen (60) umfasst, wobei jedes Erinnerungsmodul (60) einer Zelle (50) entspricht, und wenn es dazu konfiguriert ist, eine Zielzelle zu verwalten, die dem maximalen Zieläquivalent-Selbstentladungswert entspricht, ist das Verarbeitungsmodul (20) spezifisch so konfiguriert, dass es :
das der Zielzelle entsprechende Erinnerungsmodul (60) so steuert, dass es ein Frühwarnsignal ausgibt.

13. Batteriemanagementvorrichtung gemäß einem der Ansprüche 9 bis 12, die ferner ein Speichermodul (40) umfasst, wobei das Speichermodul (40) den äquivalenten Selbstentladungswert jeder Zelle speichert und das Verarbeitungsmodul (20) ferner dazu konfiguriert ist, dass es den äquivalenten Selbstentladungswert der Zelle zum vorherigen Zeitpunkt durch den aktuellen äquivalenten Selbstentladungswert jeder Zelle ersetzt, um einen gespeicherten Selbstentladungswert der Zelle zu aktualisieren;
insbesondere wobei, wenn es dazu konfiguriert ist, dass es den äquivalenten Selbstentladungswert zum vorherigen Zeitpunkt der Zelle durch den aktuellen äquivalenten Selbstentladungswert jeder Zelle ersetzt, um einen gespeicherten äquivalenten Selbstentladungswert der Zelle zu aktualisieren, das Verarbeitungsmodul (20) spezifisch so konfiguriert ist, um:
einen minimalen aktuellen äquivalenten Selbstentladungswert unter den aktuellen äquivalenten Selbstentladungswerten aller Zellen zu bestimmen;
den minimalen Stromäquivalent-Selbstentladungswert von dem Stromäquivalent-Selbstentladungswert jeder Zelle zu subtrahieren, um einen vorverarbeiteten Stromäquivalent-Selbstentladungswert jeder Zelle zu erhalten; und
den äquivalenten Selbstentladungswert der Zelle zum vorherigen Zeitpunkt durch den vorverarbeiteten Stromäquivalent-Selbstentladungswert jeder Zelle zu ersetzen, um den gespeicherten äquivalenten Selbstentladungswert der Zelle zu aktualisieren.

14. Computerlesbares Speichermedium, das ein Computerprogramm speichert, wobei das Computerprogramm von einem Prozessor aufgerufen wird, um die folgenden Schritte auszuführen:
Erhalten eines aktuellen Hochspannungs-Wendepunkt-Leistungswerts, der einem Hochspannungs-Wendepunkt einer Ladekurve jeder Zelle unter einer Vielzahl von Zellen zu einem aktuellen Zeitpunkt entspricht;
**gekennzeichnet durch**:
Ermitteln eines aktuellen historischen kumulativen Ausgleichsleistungswerts jeder Zelle zum aktuellen Zeitpunkt;
Ermitteln eines aktuellen äquivalenten Selbstentladungswerts der Zelle gemäß dem aktuellen Hochspannungs-Wendepunkt-Leistungswert jeder Zelle und dem aktuellen historischen kumulativen Ausgleichsleistungswert der Zelle;
Ermitteln eines äquivalenten Selbstentladungswerts zu einem früheren Zeitpunkt jeder Zelle;
Subtrahieren des äquivalenten Selbstentladungswerts zu einem früheren Zeitpunkt der Zelle vom aktuellen äquivalenten Selbstentladungswert jeder Zelle, um einen Zielwert für die äquivalente Selbstentladung der Zelle innerhalb eines Intervalls zwischen dem aktuellen Zeitpunkt und dem früheren Zeitpunkt zu erhalten;
Bestimmen eines maximalen Zieläquivalenzselbstentladungswerts und eines minimalen Zieläquivalenzselbstentladungswerts unter den Zieläquivalenzselbstentladungswerten aller Zellen;
Dividieren des maximalen Zieläquivalenzselbstentladungswerts durch das Intervall, um eine maximale Äquivalenzselbstentladungsrate zu erhalten, und Dividieren des minimalen Zieläquivalenzselbstentladungswerts durch das Intervall, um eine minimale Äquivalenzselbstentladungsrate zu erhalten; und
wenn festgestellt wird, dass eine Differenz zwischen der maximalen äquivalenten Selbstentladungsrate und der minimalen äquivalenten Selbstentladungsrate größer als ein voreingestellter Schwellenwert ist, Verwalten einer Zielzelle, die dem maximalen Zieläquivalent-Selbstentladungswert entspricht.

15. Computerlesbare Speichermedium gemäß Anspruch 19, das hinsichtlich des Erhaltens eines aktuellen äquivalenten Selbstentladungswerts der Zelle gemäß dem aktuellen Hochspannungs-Wendepunkt-Leistungswert jeder Zelle und dem aktuellen historischen kumulativen Ausgleichsleistungswert der Zelle ein Computerprogramm umfasst, das vom Prozessor aufgerufen wird, um die folgenden Schritte auszuführen:
Bestimmen eines minimalen aktuellen Hochspannungs-Wendepunkt-Leistungswerts unter den aktuellen Hochspannungs-Wendepunkt-Leistungswerten aller Zellen;
Subtrahieren des minimalen aktuellen Hochspannungs-Wendepunkt-Leistungswerts vom aktuellen Hochspannungs-Wendepunkt-Leistungswert jeder Zelle, um einen vorverarbeiteten aktuellen Hochspannungs-Wendepunkt-Leistungswert jeder Zelle zu erhalten;
Bestimmen eines minimalen aktuellen historischen kumulativen Ausgleichsleistungswerts unter den aktuellen historischen kumulativen Ausgleichsleistungswerten aller Zellen;
Subtrahieren des minimalen aktuellen historischen kumulativen Ausgleichsleistungswerts vom aktuellen historischen kumulativen Ausgleichsleistungswert jeder Zelle, um einen vorverarbeiteten aktuellen historischen kumulativen Ausgleichsleistungswert jeder Zelle zu erhalten; und
Subtrahieren des vorverarbeiteten aktuellen historischen kumulativen Ausgleichsleistungswerts der Zelle vom vorverarbeiteten aktuellen Hochspannungs-Wendepunkt-Leistungswert jeder Zelle, um den aktuellen äquivalenten Selbstentladungswert der Zelle zu erhalten.

## Revendications

1. Procédé de gestion de batterie, appliqué à un dispositif de gestion de batterie, le dispositif de gestion de batterie comprenant une pluralité de cellules, et le procédé de gestion de batterie comprenant les étapes suivantes:
obtenir la valeur de puissance actuelle du point d'inflexion haute tension correspondant à un point d'inflexion haute tension d'une courbe de charge de chaque cellule à un moment donné (S101); le procédé étant **caractérisé par**:
l'obtention d'une valeur de puissance d'équilibre cumulée historique actuelle de chaque cellule à l'instant présent (S102);
l'obtention d'une valeur d'autodécharge équivalente actuelle de la cellule selon la valeur de puissance actuelle du point d'inflexion haute tension de chaque cellule et selon la valeur de puissance cumulative historique actuelle de la cellule (S103);
l'obtention d'une valeur d'autodécharge équivalente à un moment précédent de chaque cellule (S104);
soustraire la valeur d'autodécharge équivalente à un moment précédent de la cellule de la valeur d'autodécharge équivalente actuelle de chaque cellule afin d'obtenir une valeur d'autodécharge équivalente cible de la cellule dans un intervalle entre le moment actuel et le moment précédent (S105);
déterminer une valeur cible maximale d'autodécharge équivalente et une valeur cible minimale d'autodécharge équivalente parmi les valeurs cibles d'autodécharge équivalente de toutes les cellules (S106);
diviser la valeur cible maximale d'autodécharge équivalente par l'intervalle pour obtenir un taux d'autodécharge équivalent maximal, et diviser la valeur cible minimale d'autodécharge équivalente par l'intervalle pour obtenir un taux d'autodécharge équivalent minimal (S107); et
lorsqu'il est déterminé que la différence entre le taux d'autodécharge équivalent maximal et le taux d'autodécharge équivalent minimal est supérieure à un seuil prédéfini, gérer une cellule cible correspondant à la valeur d'autodécharge équivalente cible maximale (S108).

2. Procédé de gestion de batterie selon la revendication 1, l'obtention d'une valeur d'autodécharge équivalente actuelle de la cellule selon la valeur de puissance actuelle du point d'inflexion haute tension de chaque cellule et la valeur de puissance cumulative historique actuelle de la cellule qui comprend:
la soustraction de la valeur de puissance d'équilibre cumulée historique actuelle de la cellule de la valeur de puissance du point d'inflexion haute tension actuelle de chaque cellule afin d'obtenir la valeur d'autodécharge équivalente actuelle de la cellule.

3. Procédé de gestion de batterie selon la revendication 1, l'obtention d'une valeur d'autodécharge équivalente actuelle de la cellule selon la valeur de puissance actuelle du point d'inflexion haute tension de chaque cellule et la valeur de puissance cumulative historique actuelle de la cellule qui comprend:
déterminer la valeur de puissance minimale au point d'inflexion haute tension actuelle parmi les valeurs de puissance au point d'inflexion haute tension actuelle de toutes les cellules (S1031);
soustraire la valeur de puissance minimale du point d'inflexion haute tension actuelle de la valeur de puissance du point d'inflexion haute tension actuelle de chaque cellule afin d'obtenir la valeur de puissance du point d'inflexion haute tension actuelle prétraitée de chaque cellule (S1032);
déterminer la valeur de puissance d'équilibre cumulée historique minimale parmi les valeurs de puissance d'équilibre cumulée historique de toutes les cellules (S1033);
soustraire la valeur de puissance d'équilibre cumulée historique minimale actuelle de la valeur de puissance d'équilibre cumulée historique actuelle de chaque cellule afin d'obtenir une valeur de puissance d'équilibre cumulée historique actuelle prétraitée de chaque cellule (S 1034); et
soustraire la valeur de puissance d'équilibre cumulée historique actuelle prétraitée de la cellule de la valeur de puissance au point d'inflexion haute tension actuelle prétraitée de chaque cellule afin d'obtenir la valeur d'autodécharge équivalente actuelle de la cellule (S1035).

4. Procédé de gestion de batterie selon l'une quelconque des revendications 1 à 3, l'appareil de gestion de batterie étant appliqué à un véhicule, et la gestion d'une cellule cible correspondant à la valeur d'autodécharge équivalente cible maximale comprenant:
l'envoi d'informations sur la cellule cible au véhicule et/ou à un terminal connecté de manière communicative au véhicule;
en particulier dans lequel les informations concernant la cellule cible comprennent un numéro, un site, la valeur d'autodécharge équivalente cible et un taux d'autodécharge équivalent de la cellule cible.

5. Procédé de gestion de batterie selon l'une quelconque des revendications 1 à 4, dans lequel le dispositif de gestion de batterie comprend en outre une pluralité de modules de rappel, chaque module de rappel correspondant à une cellule, et la gestion d'une cellule cible correspondant à la valeur cible maximale d'autodécharge équivalente comprend en outre:
commander un module de rappel correspondant à la cellule cible pour émettre un signal d'alerte précoce.

6. Procédé de gestion de batterie selon l'une quelconque des revendications 1 à 5, comprenant en outre : le remplacement de la valeur d'autodécharge équivalente à l'instant précédent de la cellule par la valeur d'autodécharge équivalente actuelle de chaque cellule afin de mettre à jour une valeur d'autodécharge équivalente stockée de la cellule;
en particulier, dans lequel le remplacement de la valeur d'autodécharge équivalente au moment précédent de la cellule par la valeur d'autodécharge équivalente actuelle de chaque cellule afin de mettre à jour une valeur d'autodécharge équivalente stockée de la cellule comprend:
déterminer une valeur d'autodécharge équivalente minimale parmi les valeurs d'autodécharge équivalentes actuelles de toutes les cellules;
soustraire la valeur d'autodécharge équivalente minimale actuelle de la valeur d'autodécharge équivalente actuelle de chaque cellule afin d'obtenir une valeur d'autodécharge équivalente prétraitée actuelle de chaque cellule; et
remplacer la valeur d'autodécharge équivalente au moment précédent de la cellule par la valeur d'autodécharge équivalente prétraitée de chaque cellule afin de mettre à jour la valeur d'autodécharge équivalente stockée de la cellule.

7. Procédé de gestion de batterie selon l'une quelconque des revendications 1 à 6, dans lequel le moment précédent est un moment auquel le véhicule quitte une usine, la valeur d'autodécharge équivalente au moment précédent de chaque cellule est 0, la valeur de puissance d'équilibre cumulée historique au moment précédent de chaque cellule est 0, et la valeur de puissance du point d'inflexion haute tension au moment précédent de chaque cellule est 0; ou
dans lequel, lorsque le moment actuel correspond à la charge actuelle, un moment de la courbe de charge est obtenu, et lorsque le moment précédent correspond à la charge précédente, un moment de la courbe de charge est obtenu.

8. Procédé de gestion de batterie selon l'une quelconque des revendications 1 à 7, dans lequel la cellule est une batterie d'alimentation ou une batterie de stockage d'énergie.

9. Appareil de gestion de batterie (100), l'appareil de gestion de batterie comprenant une pluralité de cellules (50), et comprenant en outre:
un module d'obtention (10), configuré pour obtenir la valeur de puissance actuelle du point d'inflexion haute tension correspondant à un point d'inflexion haute tension d'une courbe de charge de chaque cellule à un moment actuel, la valeur de puissance cumulative historique actuelle de chaque cellule au moment actuel, et la valeur d'autodécharge équivalente à l' e à un moment précédent de chaque cellule; et
un module de traitement (20), configuré pour obtenir une valeur d'autodécharge équivalente actuelle de la cellule selon la valeur de puissance actuelle du point d'inflexion haute tension de chaque cellule et selon la valeur de puissance cumulative historique actuelle de la cellule; soustraire la valeur d'autodécharge équivalente à l'instant précédent de la cellule de la valeur d'autodécharge équivalente actuelle de chaque cellule afin d'obtenir une valeur d'autodécharge équivalente cible de la cellule dans un intervalle entre l'instant actuel et l'instant précédent; déterminer une valeur d'autodécharge équivalente cible maximale et une valeur d'autodécharge équivalente cible minimale parmi les valeurs d'autodécharge équivalentes cibles de toutes les cellules; diviser la valeur cible maximale d'autodécharge équivalente par l'intervalle pour obtenir un taux d'autodécharge équivalent maximal, et diviser la valeur cible minimale d'autodécharge équivalente par l'intervalle pour obtenir un taux d'autodécharge équivalent minimal; et lorsqu'il est déterminé que la différence entre le taux d'autodécharge équivalent maximal et le taux d'autodécharge équivalent minimal est supérieure à un seuil prédéfini, gérer une cellule cible correspondant à la valeur d'autodécharge équivalente cible maximale.

10. Appareil de gestion de batterie selon la revendication 9, lorsqu'il est configuré pour obtenir une valeur d'autodécharge équivalente actuelle de la cellule en fonction de la valeur de puissance actuelle du point d'inflexion haute tension de chaque cellule et de la valeur de puissance cumulative historique actuelle de la cellule, le module de traitement (20) étant un spécifiquement configurée pour:
soustraire la valeur de puissance d'équilibre cumulée historique actuelle de la cellule de la valeur de puissance actuelle du point d'inflexion haute tension de chaque cellule afin d'obtenir la valeur d'autodécharge équivalente actuelle de la cellule; ou
lorsqu'il est configuré pour obtenir une valeur d'autodécharge équivalente actuelle de la cellule selon la valeur de puissance actuelle du point d'inflexion haute tension de chaque cellule et selon la valeur de puissance cumulative historique actuelle de la cellule, le module de traitement (20) étant spécifiquement configuré pou:
déterminer la valeur de puissance minimale au point d'inflexion haute tension actuelle parmi les valeurs de puissance au point d'inflexion haute tension actuelle de toutes les cellules;
soustraire la valeur minimale de puissance au point d'inflexion haute tension actuelle de la valeur de puissance au point d'inflexion haute tension actuelle de chaque cellule afin d'obtenir une valeur de puissance au point d'inflexion haute tension actuelle prétraitée de chaque cellule;
déterminer la valeur de puissance d'équilibre cumulée historique minimale parmi les valeurs de puissance d'équilibre cumulée historique actuelles de toutes les cellules;
soustraire la valeur minimale de puissance d'équilibre cumulée historique actuelle de la valeur de puissance d'équilibre cumulée historique actuelle de chaque cellule afin d'obtenir une valeur de puissance d'équilibre cumulée historique actuelle prétraitée de chaque cellule; et
soustraire la valeur de puissance d'équilibre cumulée historique actuelle prétraitée de la cellule de la valeur de puissance du point d'inflexion haute tension actuelle prétraitée de chaque cellule afin d'obtenir la valeur d'autodécharge équivalente actuelle de la cellule.

11. Appareil de gestion de batterie selon l'une quelconque des revendications 9 à 10, le dispositif de gestion de batterie étant appliqué à un véhicule, le dispositif de gestion de batterie comprenant en outre un module de communication (30) configuré pour communiquer avec le véhicule, et lorsqu'il est configuré pour gérer une cellule cible correspondant à la valeur d'autodécharge équivalente cible maximale, le module de traitement (20) étant spécifiquement configuré pour:
envoyer, par l'intermédiaire du module de communication (30), des informations sur la cellule cible au véhicule et/ou à un terminal qui est connecté de manière communicative au véhicule.

12. Appareil de gestion de batterie selon l'une quelconque des revendications 9 à 11, comprenant en outre une pluralité de modules de rappel (60), chaque module de rappel (60) correspondant à une cellule (50), et lorsqu'il est configuré pour gérer une cellule cible correspondant à la valeur cible maximale d'autodécharge équivalente, le module de traitement (20) étant spécifiquement configuré pour:
commander le module de rappel (60) correspondant à la cellule cible pour émettre un signal d'alerte précoce.

13. Appareil de gestion de batterie selon l'une quelconque des revendications 9 à 12, comprenant en outre un module de stockage (40), le module de stockage (40) stockant la valeur d'autodécharge équivalente de chaque cellule, et le module de traitement (20) étant en outre configuré pour remplacer la valeur d'autodécharge équivalente au moment précédent de la cellule par la valeur d'autodécharge équivalente actuelle de chaque cellule afin de mettre à jour une valeur d'autodécharge stockée de la cellule;
en particulier, dans lequel le module de traitement (20) est spécifiquement configuré pour afin de remplacer la valeur d'autodécharge équivalente au moment précédent de la cellule par la valeur d'autodécharge équivalente actuelle de chaque cellule afin de mettre à jour une valeur d'autodécharge équivalente stockée de la cellule, dans lequel le module de traitement (20) est spécifiquement configuré pour:
déterminer la valeur d'autodécharge équivalente minimale parmi les valeurs d'autodécharge équivalentes actuelles de toutes les cellules;
soustraire la valeur d'autodécharge équivalente minimale du courant de la valeur d'autodécharge équivalente du courant de chaque cellule afin d'obtenir une valeur d'autodécharge équivalente du courant prétraitée de chaque cellule; et
remplacer la valeur d'autodécharge équivalente à l'instant précédent de la cellule par la valeur d'autodécharge équivalente prétraitée de chaque cellule afin de mettre à jour la valeur d'autodécharge équivalente stockée de la cellule.

14. Support d's de stockage lisible par ordinateur, stockant un programme informatique, le programme informatique étant invoqué par un processeur pour effectuer les étapes suivantes:
obtenir la valeur de puissance du point d'inflexion haute tension actuelle correspondant à un point d'inflexion haute tension d'une courbe de charge de chaque cellule parmi une pluralité de cellules à un moment donné;
**caractérisé par**:
obtenir une valeur de puissance d'équilibre cumulée historique actuelle de chaque cellule à l'instant présent;
obtenir une valeur d'autodécharge équivalente actuelle de la cellule selon la valeur de puissance actuelle du point d'inflexion haute tension de chaque cellule et selon la valeur de puissance cumulative historique actuelle de la cellule;
obtenir une valeur d'autodécharge équivalente à un moment précédent de chaque cellule;
soustraire la valeur d'autodécharge équivalente à l'instant précédent de la cellule de la valeur d'autodécharge équivalente actuelle de chaque cellule afin d'obtenir une valeur d'autodécharge équivalente cible de la cellule dans un intervalle entre l'instant actuel et l'instant précédent;
déterminer une valeur cible maximale d'autodécharge équivalente et une valeur cible minimale d'autodécharge équivalente parmi les valeurs cibles d'autodécharge équivalente de toutes les cellules;
diviser la valeur cible maximale d'autodécharge équivalente par l'intervalle pour obtenir un taux d'autodécharge équivalent maximal, et diviser la valeur cible minimale d'autodécharge équivalente par l'intervalle pour obtenir un taux d'autodécharge équivalent minimal; et
lorsqu'il est déterminé que la différence entre le taux d'autodécharge équivalent maximal et le taux d'autodécharge équivalent minimal est supérieure à un seuil prédéfini, gérer une cellule cible correspondant à la valeur d'autodécharge équivalente cible maximale.

15. Support de stockage lisible par ordinateur selon la revendication 19, en termes d'obtention, selon la valeur de puissance actuelle du point d'inflexion haute tension de chaque cellule et selon la valeur de puissance cumulative historique actuelle de la cellule, d'une valeur d'autodécharge équivalente actuelle de la cellule, le programme informatique étant invoqué par le processeur pour effectuer les étapes suivantes:
déterminer la valeur de puissance minimale au point d'inflexion haute tension parmi les valeurs de puissance actuelles au point d'inflexion haute tension de toutes les cellules;
soustraire la valeur minimale actuelle de puissance au point d'inflexion haute tension de la valeur actuelle de puissance au point d'inflexion haute tension de chaque cellule afin d'obtenir une valeur prétraitée actuelle de puissance au point d'inflexion haute tension de chaque cellule;
déterminer la valeur de puissance d'équilibre cumulée historique minimale parmi les valeurs de puissance d'équilibre cumulée historique de toutes les cellules;
soustraire la valeur minimale actuelle de puissance d'équilibre cumulée historique de la valeur actuelle de puissance d'équilibre cumulée historique de chaque cellule afin d'obtenir une valeur prétraitée actuelle de puissance d'équilibre cumulée historique de chaque cellule; et
soustraire la valeur de puissance d'équilibre cumulée historique actuelle prétraitée de la cellule de la valeur de puissance du point d'inflexion haute tension actuelle prétraitée de chaque cellule afin d'obtenir la valeur d'autodécharge équivalente actuelle de la cellule.
